(19) Europäisches Patentamt
European Patent Office
Office européen des brevets

(11) **EP 4 600 740 A2**

(12) **EUROPEAN PATENT APPLICATION**

(43) Date of publication:
**13.08.2025 Bulletin 2025/33**

(21) Application number: **25186484.9**

(22) Date of filing: **30.06.2025**

(51) International Patent Classification (IPC):
**G03F 7/00** (2006.01)

(52) Cooperative Patent Classification (CPC):
**G03F 7/706837**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(71) Applicant: **ASML Netherlands B.V.**
**5500 AH Veldhoven (NL)**

(72) Inventors:
• **VERHEUL, Nick**
**5500 AH Veldhoven (NL)**
• **ONOSE, Alexandru**
**5500 AH Veldhoven (NL)**
• **SEMKIV, Mykhailo**
**5500 AH Veldhoven (NL)**
• **SOARES DUARTE, Alex**
**5500 AH Veldhoven (NL)**
• **DIRKS, Remco**
**5500 AH Veldhoven (NL)**

(74) Representative: **ASML Netherlands B.V.**
**Corporate Intellectual Property**
**P.O. Box 324**
**5500 AH Veldhoven (NL)**

(54) **MULTI-WAVELENGTH HYBRID SAMPLING FOR ACCURACY IMPROVEMENTS**

(57)    There is provided a method of predicting a parameter of interest (POI) for each target of a first set of targets formed by a patterning process on a substrate comprising a plurality of targets comprising the first set of targets and a second set of targets. The method comprises obtaining i) a first dataset comprising, for each target of the second set, a respective POI value generated from metrology data obtained by a first metrology process, ii) obtaining a second dataset comprising, for each target of the first set and each target of the second set, a respective POI value generated from metrology data obtained by a second metrology process, and iii) processing the first dataset and the second dataset to predict the respective POI value for each target of the first set, wherein the predicted value is a prediction of the POI generated from metrology data obtained by applying the second metrology process to the first set of targets.

**Fig. 6**

600

Substrate 601

Metrology system 602

Metrology system 603

Sparsely sampled metrology data 607

Densely sampled metrology data 608

POI module 604

POI module 605

Sparse POI data 609

Dense POI data 610

Processing unit 606

Predicted POI data 611

**Description**

FIELD

The present invention relates to a method of predicting a value of a parameter of interest for a target of a first set of targets formed by a patterning process on a substrate comprising a plurality of targets, a computer program product and a metrology apparatus to carry out such method.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

After a substrate has been patterned using the lithographic apparatus, it is often desirable to inspect the substrate (i.e. to measure properties of the patterned structure), e.g. to determine whether the produced pattern accurately resembles the intended design. To this end, a metrology system (e.g. optical metrology systems, scanning electron microscopes (SEM), soft x-ray metrology systems, and the like) can be used to acquire metrology data (any measured signals such as image(s)) of the patterned substrate. The acquired metrology data is often further processed using specialised algorithms to infer an estimate of one or more parameters of interest (POI) such as overlay values. The so-determined POI can be used to adjust process parameters (e.g. scanner settings or conditions, etch process parameters, and the like) which specify the manufacturing process of the patterned substrate e.g. to improve performance and yield of the semiconductor devices made with the same manufacturing process.

The accuracy of the determined POI depends on the accuracy of the metrology data which in turn depends on the employed metrology process. That is, different metrology systems normally realise different speed-accuracy trade-offs where, generally, faster measurements are less accurate (e.g. lower signal-to-noise ratio, stronger bias, or the like), and more accurate measurements cost more time. Frequently the patterned substrate includes a plurality of nominally identical target structures. In these cases, it is desirable to obtain accurate POI values for each target. It is therefore desirable to provide techniques that can achieve this in a time-efficient manner.

SUMMARY

The present invention aims to provide new and useful methods and systems for predicting values of at least one parameter of interest (POI) for at least one of a plurality of targets formed on a substrate. More specifically, the proposed techniques involve processing an "incomplete" POI dataset (i.e. a dataset that includes POI data for only some of the targets) to infer the "missing" POI values, where the incomplete POI dataset has been determined from metrology data generated using a first metrology process (e.g. a slow but accurate metrology process). In broad terms, this is achieved by combining information contained in the incomplete POI dataset with information contained in a "complete" POI dataset determined from metrology data generated using a second (i.e. different) metrology process (e.g. a fast but inaccurate metrology process).

According to a first aspect, there is provided a (computer-implemented) method of predicting a value of a parameter of interest (POI) for a target of a first set of targets formed by a patterning process on a substrate comprising a plurality of targets. The term "target" generally refers to any portion of the substrate. A target may include a structure formed according to a pre-determined design. The structure can include one or more layers spaced apart in directions transverse to and/or in the plane of the major surface of the substrate, and/or one or more vertical surfaces (sidewalls). In some implementations, the substrate may be a semiconductor wafer patterned using a lithography apparatus. In these cases, the targets may, for example, be (part of) a semiconductor circuit/device, or metrology targets, i.e. structures designed to enable certain types of metrology processes (e.g. the targets may be μDBO (micro diffraction-based overlay) targets for μDBO metrology). The plurality of targets may be nominally identical, e.g. the targets may have been formed according to the same design data. In some implementations, when the targets are metrology targets, the plurality of targets may be "after (photo resist)-development inspection" (ADI) targets or "after-etch inspection" (AEI) targets. Generally, ADI targets and AEI targets may comprise gratings in two layers, separated by a distance. An ADI target may comprise a specific pattern designed for metrology measurements (e.g. a top grating) that exists in developed photoresist only. An AEI target is a target for which, after the step of exposing the upper grating, the layer(s) below are etched into (before inspection).

The plurality of targets comprise or consist of the first set of targets and a second set of targets. The targets of the second set are different from the targets of the first set of targets. That is the first and second sets of targets are proper and nonoverlapping subsets of the plurality of targets. In some implementations, the plurality of targets may additionally comprise a third set of targets which are different from the first and second set of targets. Optionally, the substrate may comprise further targets, for some of which metrology data is available, but which are not employed by the processes discussed here.

In principle, it would be possible to use the present process in a case in which the POI is metrology data itself. However, generally, the POI is a parameter which is derived by processing captured metrology data (i.e. it cannot be captured by the first or second metrology process). The POI may be indicative of the performance (e.g. accuracy) of the patterning process. The POI may be indicative of a discrepancy between the intended design of the target and the realized target. More specifically, the POI may characterize the geometry and/or material properties of the target. In some implementations, the POI is one of: an overlay value characterizing relative positions of structures of the substrate in directions in the plane of the major surface of the substrate; a critical dimension value characterizing one or more dimensions of a structure of the substrate; a side wall angle of a wall of the structure of the substrate; and a measure of a tilt of the structure of the target.

The method comprises obtaining a first dataset comprising, for each target of the second set, a respective value of the parameter of interest generated from metrology data obtained by applying a first metrology process to the second set of targets, and obtaining a second dataset comprising, for each target of the first set and each target of the second set, a respective value of the parameter of interest generated from metrology data obtained by applying a second metrology process to the first and second set of targets. The term "metrology data" generally refers to data generated by a metrology system that implements a respective metrology process using one or more sensors to capture measurements (measurement signals) from a target. In some implementations, the metrology data that has been used to generate the datasets is "after (photo resist)-development inspection" (ADI) metrology data or "after-etch inspection" (AEI) metrology data.

Generally, the second metrology process is less resource-intensive than the first metrology process, but POI values generated from metrology data obtained by applying the second metrology process are less accurate (e.g. stronger biased) than POI values generated from metrology data obtained by applying the first metrology process. As one example, the first metrology process may comprise a multi-wavelength acquisition (e.g. a dual wavelength acquisition, or acquisition using three of more wavelengths), and the second metrology process may comprise a single-wavelength measurement (or more generally, using a smaller number of wavelengths than the first metrology process). In this case, acquiring multi-wavelength acquisitions takes more time than single-wavelength acquisitions but POI values generated from multi-wavelength acquisitions may be more accurate than the POI values generated from single-wavelength acquisitions because multi-wavelength acquisitions are normally less biased compared to single-wavelength acquisitions. As another example the first metrology process may be an optical metrology process using light having a first polarization state, and the second metrology process is an optical metrology process using light having a second polarization state that is different from the first polarization state (in some implementations, the second metrology process may comprise acquiring a plurality images, each using a different polarization state). As yet another example, the first metrology process may comprise measuring the substrate both at 0-degree rotation and at 180-degree rotation, and the second metrology process comprises measuring the substrate only at 0-degree rotation. As yet another example, the first metrology process comprises measuring two grating light valve (GLV) spectra, and the second metrology process comprises measuring one grating light valve spectrum. Any combination of these possibilities is also possible. It is possible in principle for the first metrology process to be more accurate in some respects (e.g. employ more wavelengths) and for the second metrology process to be more accurate in others (e.g. employ more rotation positions), but in some implementations the first metrology process is more accurate than the second metrology in all respects.

The method further comprises processing the first dataset and the second dataset to predict the value of the parameter of interest for at least one target of the first set, wherein the predicted value is a prediction of the POI generated from metrology data obtained by applying the first metrology process to the first set of targets (in some implementations, POI values for each target of the first set may be predicted). That is, the predicted POI value(s) "look", e.g. with respect to bias and/or noise, like POI values generated from metrology data obtained by using the first metrology process. Thus, the predicted POI value(s) for the target(s) of the first set are more accurate than the corresponding POI value(s) measured with the second metrology process. Thus, the proposed method improves throughput because accurate POI values for all targets on the substrate are generated without having to measure all targets with the accurate but resource-intensive first metrology process.

In some implementations, processing the first dataset and the second dataset to predict a value of the POI for the target of the first set may comprise: using the first dataset and the second dataset to define a cost function of a respective candidate value of the POI for each target of the first set and for each target of the second set; and predicting the value of the POI for the target of the first set based on the cost function (in some implementations, the respective value of the POI for each target of the first set may be predicted based on the cost function). This may involve performing an iterative process of varying the candidate values of the POI to reduce the value of the cost function; and predicting the value of the POI for the target of the first set based on the respective candidate values resulting from the iterative process. An alternative, is for the candidate values of the POIs to be (or to be based on) outputs of a machine learning model upon processing the first and second datasets, where the operation of the machine learning model is defined by a plurality of machine learning numerical parameters. In this case, the iterative process may be a process of iteratively varying the machine learning numerical parameters, to vary the candidate values of the POIs, thereby reducing the value of the cost function. The cost function may involve corresponding terms based on further instances of the first and second datasets (e.g. obtained by metrology of other substrates). This trains the machine learning model, so that it becomes adapted to predict POIs from a future instance of a corresponding first and second dataset.

The cost function may be a weighted combination of one or more cost terms. The cost terms may comprise "data terms" that penalise discrepancies between the predicted values of the second set of targets and the values of the first dataset. There may be other cost terms, referred to as "prior terms". These are functions of the predicted values for both the first and second set of targets. Various prior terms express expected properties or behaviours of the predicted values for both the first and second targets such as expected correlations between the predicted values for both the first and second targets, or between their gradient values based on them, or between gradient values based one on or other of them and gradient values indicative of spatial gradients (trends) in the first and second datasets. In some implementations, the cost function comprises at least one data term and one prior term. Using more data prior terms normally improves the accuracy of the predicted values.

In some implementations, the cost may comprise comprises a data fidelity term (which is an example of a data term) measuring a discrepancy between the candidate values for the parameter of interest for the target of the second set and the corresponding values of the first dataset.

In some implementations, the cost function may further comprise a spatial variation term encoding domain knowledge of the patterning process relating to a spatial variation of the value of the parameter of interest across the targets of the first and second set. The spatial variation term is an example of a prior term. The spatial variation term may measure a total-variation of the candidate value of the parameter of interest across the targets of the first and second set.

In some implementations, the cost function may comprise a first correlation term measuring a correlation between the candidate values of the parameter of interest across the targets of the first and second set. The first correlation term is another example of a prior term. The first correlation term may measure a covariance of the candidate values of the parameter of interest across the targets of the first and second set.

In some implementations, the cost function may further comprise a second correlation term measuring a discrepancy between a spatial gradient of the candidate values of the parameter of interest and corresponding spatial gradient values based on the second dataset. The second correlation term is another example of a prior term.

In some implementations, the substrate is a first substrate, and the cost functions may further be a function of POI data obtained from a second substrate that is different from but nominally identical to the first substrate. More specifically, the method may further comprise: obtaining a third dataset comprising, for at least one target of the first set of targets, a respective value of the parameter of interest generated from metrology data obtained by applying the first metrology process to the respective target of the second substrate. In this case, the cost function further may comprise a third correlation term measuring a correlation between the candidate values of the parameter of interest and corresponding values of the third dataset. The third correlation term may measure a discrepancy between the candidate values of the parameter of interest and corresponding values of the third dataset. For example, the third correlation term may measure a discrepancy between a spatial gradient of the candidate values of the parameter of interest and corresponding values of the third dataset.

In some implementations, the method also infers correction values for the POI values of the second dataset. More specifically, the cost function may be additionally a function of a respective correction value for each of the values of the second dataset. In this case, the cost function may comprise a data fidelity term based on the candidate values of the parameter of interest and the correction values, and at least one second correlation term measuring a discrepancy between candidate correction values of the first set of targets and corresponding values of the second dataset. For example, the second correlation term may measure a discrepancy between a spatial gradient of the candidate values of the parameter of interest and corresponding spatial gradient values for the second dataset.

In some implementations, POI data obtained from a nominally identical "reference" substrate (again different from the first substrate, but based on the same design data as the first substate; for example, it may be a substrate which is fabricated together with the first substrate, e.g. as part of the same production lot) may be processed to select which targets of the (first-mentioned) substrate form the first set of targets. More specially, the method may further comprise (e.g. as an initial step): obtaining a fourth dataset comprising, for each target of the plurality of targets of a reference substrate that is nominally identical to the substrate, a respective value of the parameter of interest generated from metrology data obtained by applying the first metrology process to the targets; obtaining a fifth dataset comprising, for each target of the plurality of targets of the reference substrate, a respective value of the parameter of interest generated from metrology data obtained by applying the second metrology process to the targets; and processing the fourth dataset and the fifth dataset to obtain mask data specifying an assignment of each of the plurality of targets to either the first set of targets or the second set of targets. The mask data can be considered to specify a selection of the targets that are most relevant and thus should be included in the first set of targets, i.e. should be inspected using the first metrology process. In this way, the number of measurements that need to be performed using the resource-intensive first metrology process can be minimized.

In these implementations, obtaining the first dataset may comprise: applying, based on the mask data, the first metrology process to each of the targets of the first set of targets of the substrate to generate corresponding metrology data; processing the generated metrology data to determine corresponding values of the parameter of interest.

Further, processing the fourth dataset and the fifth dataset to obtain mask data specifying an assignment of each target to either the first subset or the second subset comprises: processing the fourth dataset and the fifth dataset to obtain the mask data based on a second cost function comprising i) a respective data fidelity term measuring, based on candidate mask data, a discrepancy between candidate values for the parameter of interest for each target of the second set according to the candidate mask data and the corresponding values of the fourth dataset, and ii) one or more of:

a respective gradient term encoding domain knowledge of the patterning process relating to a spatial variation of the value of the parameter of interest across the targets of the first and second set;

a respective first correlation term measuring a correlation between the candidate values of the parameter of interest across the targets of the first and second set;

a respective second correlation term measuring a discrepancy between a spatial gradient of the candidate values of the parameter of interest and corresponding values of the fifth dataset.

In some implementations, processing the fourth dataset and the fifth dataset to obtain the mask data based on a second cost function may comprise: over a plurality of iterations, alternatingly optimizing i) data relating to the candidate mask data and ii) the candidate values for the parameter of interest for each target of the second set based on the second cost function, and providing the candidate mask data of the last iteration as the mask data. This may involve performing a first iteration routine comprising a plurality of first iteration steps, each first iteration step comprising:

updating a continuously scaling operator specifying a respective weight for each target based on the second cost function, wherein the weight is indicative of an importance of the target for the optimization of the candidate values for the parameter of interest for each target of the second set; and

updating, separately from the updating of the continuously scaling operator, the candidate values for the parameter of interest for each target of the second set based on the second cost function;

performing a second iteration routine comprising a plurality of second iteration steps, each second iteration step comprising processing the continuously scaling operator to encourage convergence to binary values;

and generating the mask data from the processed continuously scaling operator.

In some implementations, first and the second iteration routines may be alternatingly performed a plurality of times, and the mask data is generated from the processed continuously scaling operator obtained in the last iteration of the second iteration routine.

In some implementations, when the plurality of targets comprise a third set of targets for which the first and second datasets do not comprise corresponding data elements, the first dataset and the second dataset are processed to predict the respective value of the parameter of interest for each target of the first set and for each target of the third set.

According to a second aspect, there is provided a computer program product comprising machine-readable instructions which, when the program is executed by a computer, cause the computer to carry out the method of the first aspect.

A metrology apparatus for predicting a value of a parameter of interest for a target of a first set of targets formed by a patterning process on a substrate comprising a plurality of targets, the plurality of targets comprising the first set of targets and a second set of targets which are different from the first set of targets. The metrology apparatus comprises:

a first metrology system configured to apply a first metrology process to the second set of targets to obtain first metrology data;
a second metrology system configured to apply a second metrology process to the first and second set of targets to obtain second metrology data;
a processing unit (e.g. implemented on one or more computers) configured to:

process the first metrology data to obtain a first dataset comprising, for each target of the second set, a respective value of the parameter of interest;
process the second metrology data to obtain a second dataset comprising, for each target of the first set and each target of the second set, a respective value of the parameter of interest generated from metrology data obtained by applying a second metrology process to the first and second set of targets; and
processing the first dataset and the second dataset to predict the value of the parameter of interest for a target of the first set (e.g. as above described with respect to the first aspects). The predicted value is a prediction of the parameter of interest generated from metrology data obtained by applying the first metrology process to the target of the first set.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts schematically an example system for predicting POI data which is an embodiment of the invention;
- Figure 7 illustrates example POI data;
- Figure 8 is a flow diagram of a process of predicting POI data which is an embodiment of the invention; and
- Figures 9 and 10 depict schematically a process of obtaining mask data which is an embodiment of the invention.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultraviolet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

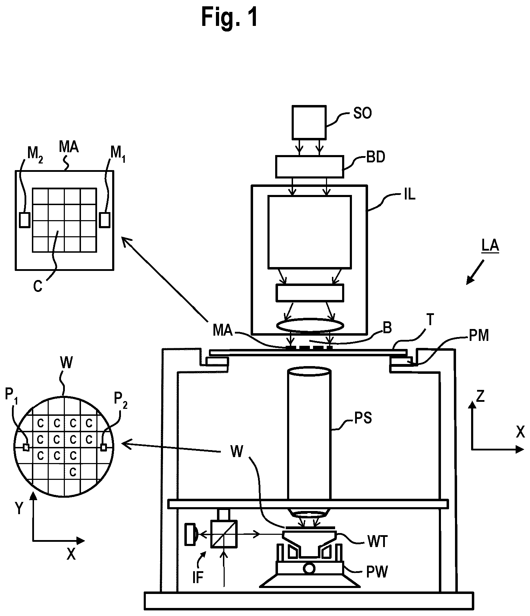

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

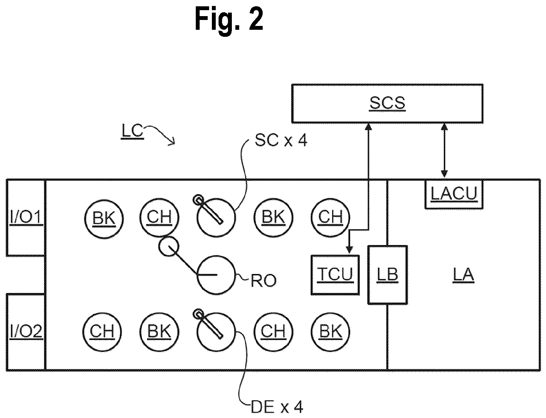

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

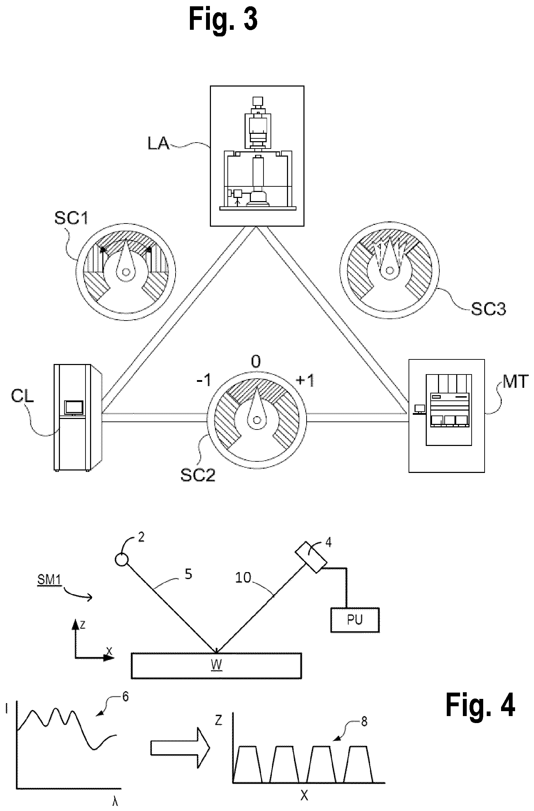

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

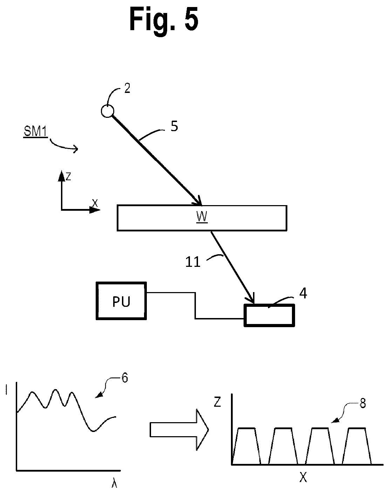

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

To improve the yield of a semiconductor manufacturing process, it is often desirable to use metrology systems (e.g. optical metrology systems, scanning electron microscopes (SEM), or soft x-ray metrology systems) to inspect a patterned substrate to generate metrology data (or "machine measurement/observation") which is then further processed to determine one or more parameters of interest (POI) such as overlay, critical dimension, tilt, angle errors, and the like. For example, the substrate may be inspected as part of an after-develop inspection (ADI) or an after-etch inspection (AEI), and the generated metrology data is then processed using a specialized algorithm/model which implements a mapping of metrology data (e.g. pupils in AEI, or $\mu$DBO (micro diffraction-based overlay) images in ADI) to inferred POIs. Frequently the patterned substrate includes a plurality of nominally identical target structures, i.e. the same target structure is repeated on several locations across substrate. In this case, it is desirable to obtain an accurate POI value for each target. This is because the target structures, although nominally identical, are often not exactly identical due to undesired (but practically unavoidable) variations and fluctuations of the patterning process. A collection of POI values for multiple targets on the same substrate is sometimes referred to as a POI "fingerprint" of the substrate.

As noted above, the accuracy of the determined POIs depends on the accuracy of the metrology data which in turn depends on the metrology process employed to capture it. As one example, an optical metrology process may suffer from an acquisition bias, i.e. metrology data generated by the optical metrology process may be biased where the bias originates from the wavelength of the light used to make measurements. Typically, even if all other acquisition settings are equal, the machine observations for two different wavelengths are themselves very different e.g. because the optical properties of the target structure, surroundings, and sensor are normally wavelength dependent. In other words, on top of measurement uncertainty/noise (introduced by sensor variation, source fluctuation, etc.), each machine observations $D_{\lambda_i}$ is biased toward that $\lambda_i$'s particular signal response (where $\lambda_i$ denotes a wavelength from a set of wavelengths, $\lambda_i \in \{\lambda_1, ... , \lambda_L\}$), where $L$ is any integer, e.g. greater than one. Thus, each wavelength "sees" the target and the POI differently.

One way to reduce the acquisition bias is to "correct" POIs generated from SWL data. For example, a computational model can be trained to remove the acquisition bias from POIs generated from SWL data based on training data that includes pairs of POIs generated from training SWL data and "ground truth" POIs generated from metrology data acquired using an accurate reference metrology system (e.g. a SEM metrology system). A problem with this approach is that the correction performance (i.e. the accuracy of the correction) of the so-trained model degrades quickly over time since the model effectively learned a static correction fingerprint (e.g. the trained model cannot account for process drifts). This means that the model requires frequent recalibrations which in turn requires time-intensive measurements using the reference metrology system.

Another way to reduce the acquisition bias of single wavelength (SWL) optical metrology processes is to acquire metrology data for multiple wavelengths (MWL). While POIs can be inferred more accurately (i.e. with less bias) from MWL data, acquiring MWL reduces the throughput because acquiring data for each target location for multiple wavelengths takes significantly longer than only acquiring data for a single wavelength.

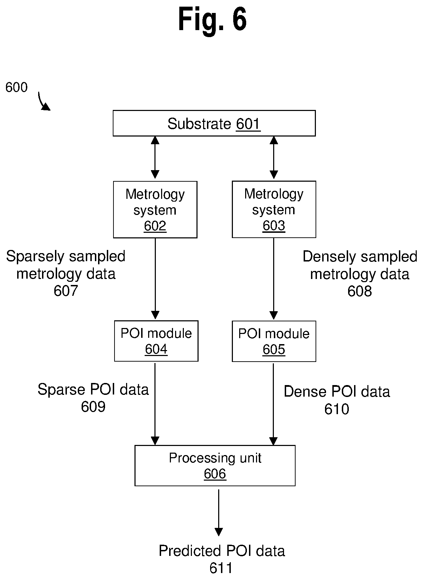

Thus, an accurate POI value for each target can be obtained by inspecting each target with an "accurate" metrology process to generate metrology data which is further processed to determine the POI value. However, such a process is time-intensive because determining accurate POI values requires using a slow metrology process. With reference to Figures 6 to 9, example systems and processes are described that address at least some of the aforementioned problems. In particular, the inventors have realised that accurate POI values can be inferred by combining information obtained from different metrology processes so that not all targets need to be measured with accurate but slow metrology processes. This reduces the overall measurement time per substrate and thus increases the throughput of the manufacturing process.

Figure 6 shows a system 600 comprising a substrate 601, a first metrology system 602, a second metrology system 603, a first POI module 604, a second POI module 605, and a processing unit 606. It is to be understood that the processing unit 606, the first POI module 604, and the second POI module 605 may be implemented on the same or on different computer systems which can comprise one or more computers.

The substrate 601 is a silicon wafer which has been patterned using a lithography apparatus to include a plurality of nominally identical target structures. The plurality of target structure can be considered to comprise or consist of a first set of targets, a second set of target and, optionally, a third set of targets, where each set comprises different instances of the nominally identical targets.

In overview, the system 600 implements a weakly supervised optimization routine that infers POIs of the target structures by combining measurement information acquired using different metrology processes (e.g. measurement information acquired using different acquisition modes of an optical metrology process, such as SWL and MWL acquisitions). Specifically, the proposed optimization routine implements presents an efficient way to improve the accuracy of inferred POIs using "dynamic" corrections based on differently sampled SWL and MWL acquisitions without significant impacting on throughput. As described below in more detail, the optimization routine solves an inverse problem (sometimes referred to as "signal inpainting") that aims to infer missing or corrupted signals, e.g. "missing" POI values for targets for which no MWL acquisitions have been acquired.

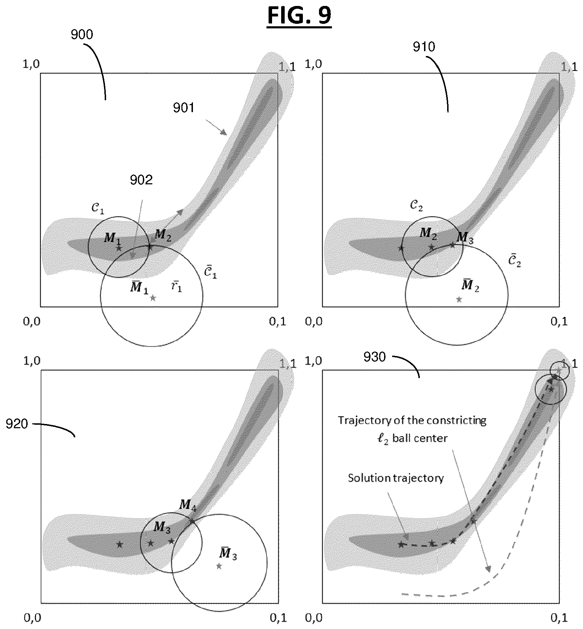

The first metrology system 602 is configured to apply a first metrology process to the substrate 601. In the example of Figure 6, the first metrology system 602 is configured to implement a first optical metrology process. Specifically, the first metrology system 602 is configured to capture, as metrology data 607, MWL images (e.g. MWL μDBO images) for a target of the second set of targets (i.e. the metrology data 607 includes only metrology data for a proper subset of the plurality of targets). The metrology data 607 is considered "sparsely sampled" because the second set of targets includes only a small fraction of the plurality of targets, i.e. only a small fraction of the targets of the substrate 601 is sampled by the first metrology system 602 (e.g. less than 33% or less than 10% of the plurality of targets on the substrate). The targets which are sampled by the first metrology system, i.e. the targets which are assigned to the second set of targets, may be randomly sampled from the plurality of targets or may be selected based on a pre-determined selection. A process of selecting the targets of the second set from the plurality of targets is described further below with reference to Figure 9.

The second metrology system 603 is configured to apply a second metrology process to the substrate 601. In the example of Figure 6, the second metrology system 603 is configured to implement a second optical metrology process. Generally, the second optical metrology process can be less resource-intensive than the first metrology optical metrology process (e.g. requiring less time, energy, materials, and/or computing resources). Specifically, the second metrology system 603 is configured to capture, as metrology data 608, SWL images (e.g. SWL μDBO images) for a target of the first and second set of targets. The metrology data 608 is considered "densely sampled" because a large fraction of the targets of the substrate 601 is sampled by the second metrology system 603 (e.g. more than 66% of the plurality of targets on the substrate). It is to be understood that, in some implementations, the first and second metrology systems 602, 603 are the same metrology system operating according to different operating/configuration settings.

While the example of Figure 6 is described as using a first metrology process that generates MWL images and a second metrology process that generates SWL images, it is to be understood that other embodiments can use different types of metrology processes (e.g. different optical metrology process, scanning electron microscopes (SEM) metrology, soft x-ray metrology, and the like).

The first POI module 604 is configured to implement a computational model or algorithm that maps metrology data generated using the first metrology process to corresponding POI values. Suitable computational models/algorithms are known to those skilled in the art. More specifically, the POI module 604 is configured to process the sparsely sampled metrology data 607 ("first dataset") to generate a correspondingly "sparse" dataset 609 of POI values which includes a respective POI value for each target in the second subset of targets. In the example of Figure 6, the POI module 604 infers an overlay error for each target in the second subset of targets (a numerical value indicative of how well layers of the target are aligned to each other).

Similar to the first POI module 604, the second POI module 605 is configured to implement a computational model or algorithm that maps metrology data generated using the second metrology process to corresponding POI values. More specifically, the POI module 605 is configured to process the densely sampled metrology data 608 ("second dataset") to generate a correspondingly "dense" dataset of POI values 610 which includes a respective POI value for each target in the first and second subsets of targets. The first POI module 604 and the second POI module 605 infer the same type of POI, i.e. in the example of Figure 6, both modules 604, 605 infer, as POI, overlay errors for the respective targets. The values of the dense POI data 610 generated from the densely sampled metrology data 608 are normally less accurate (e.g. more noisy or more biased) than the values of the sparse POI data 609 generated from the sparsely sampled metrology data 607. This is because the second metrology process generates metrology data that is less accurate (e.g. more noisy or more biased) than the first metrology process.

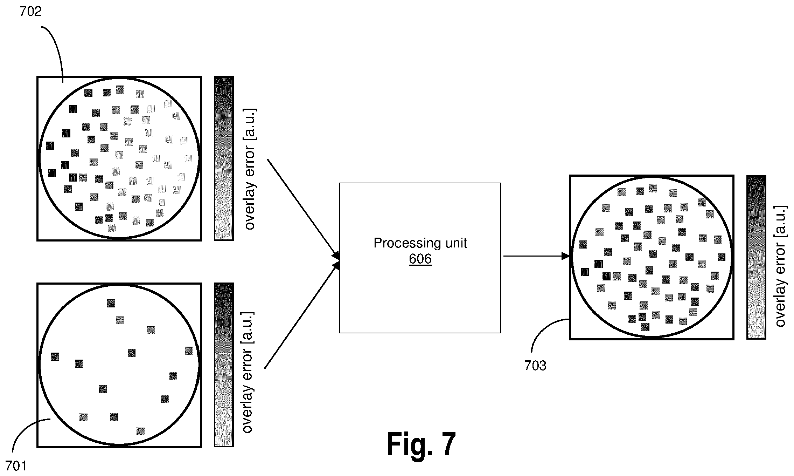

The processing unit 606 is configured to process the sparse POI data 609 and the dense POI data 610 to generate predicted POI data 611 which includes a predicted POI value for a target of the first set of target. More specifically, each predicted POI value is a prediction of the POI when generated from metrology data obtained by applying the first metrology process to the first set of targets. This is illustrated in Figure 7 which shows a sparsely sampled MWL overlay "fingerprint" 701 and a densely sampled SWL overlay "fingerprint" 702 being provided as input to the processing unit 606 which generates as output the predicted MWL overlay "fingerprint" 703. It can be seen that there is a gradient in the overlay values of the SWL overlay fingerprint 702 which is not present in the MWL overlay fingerprint 701. The predicted MWL overlay fingerprint 703 includes a predicted overlay value for each target for which the SWL overlay fingerprint 702 included data. It can be seen that the aforementioned gradient is not present in the overlay values of the predicted MWL overlay fingerprint 703, i.e. the predicted MWL overlay fingerprint 703 "looks" like the sparse POI data 609, i.e. as if it has been generated from the second (MWL) metrology process.

More specifically, the processing unit 606 is configured to generate the predicted POI data 610 by iteratively solving a minimization problem which can be expressed as a task of optimizing a cost function $\mathcal{L}$. The specific form of a suitable cost function $\mathcal{L}$ depends on implementation details. Generally, the cost function $\mathcal{L}$ may include one or more terms designed to measure corresponding one or more aspects of the predicted POI data 610 and/or one or more relationships between candidate values for the predicted POI data 610 and the input POI data 609, 610.

The cost function $\mathcal{L}$ may be expressed as

$$\mathcal{L}(X_{SWL}, X_{MWL}) = DF(X_{SWL}, X_{MWL}) + \gamma_{GP}\, GP(X_{MWL}) + \gamma_{CR}\, CR(X_{SWL}, X_{MWL}) +$$
$$\gamma_{DN}\, DN(X_{SWL}, X_{MWL}) \qquad \text{Eq. (1)}$$

where $X_{MWL}$ and $X_{SWL}$ denote respective candidate POI fingerprints, i.e. ordered arrays of numerical values (e.g. a matrix or a vector) that include, for each target of the plurality of targets (i.e. for each target of the first, second and, when present, third set of targets) a respective candidate value for a POI value as measured by the corresponding metrology process (e.g. in the absence of noise). These two fingerprints are optimization variables (i.e. the variables with respect to which the cost function is minimized). The functions $DF(X_{SWL}, X_{MWL})$, $GP(X_{MWL})$, $CR(X_{SWL}, X_{MWL})$ and $DN(X_{SWL}, X_{MWL})$ in Eq. (1) denote respectively data fidelity, spatial variation priors, correlation, and denoising cost terms, as described below in more detail. The coefficients $\gamma_{GP}$, $\gamma_{CR}$, and $\gamma_{DN}$ ($\gamma_{GP}$, $\gamma_{CR}$, $\gamma_{DN} \geq 0$) denote regularization strengths of the aforementioned functions. Generally, the terms of the cost function $\mathcal{L}$ are selected such that, when the cost function $\mathcal{L}$ is minimized with respect to the optimization variables $X_{SWL}$ and $X_{MWL}$, i.e.

$$\underset{X_{SWL}, X_{MWL}}{arg\,min}\; \mathcal{L}(X_{SWL}, X_{MWL}) \qquad \text{Eq. (2)},$$

the optimized values for $X_{SWL}$ and $X_{MWL}$ "look" like densely sampled POI fingerprints generated from respectively SWL or MWL metrology data. The optimized fingerprint $X_{MWL}$ is output as predicted POI data 611.

The data fidelity term $DF$ penalises large distances (i.e. large discrepancies) between the optimization variables and the corresponding measured data. More specifically, the data fidelity term $DF$ penalises, for the targets of the second set of targets, large distances between the corresponding optimization variable $X_{MWL}$ and the corresponding sparse POI data 609. To this end, the data fidelity term $DF$ can comprise a first (MWL) data fidelity term $DF_{MWL} = \|M_{MWL}X_{MWL} - W_{MWL}\|$, where $W_{MWL}$ denotes the sparse POI data 609, and $M_{MWL}$ denotes a binary selection mask which selects the elements of $X_{MWL}$ which correspond to targets for which MWL data is available, i.e. the elements for which $W_{MWL}$ contains measured values. Note that the first data fidelity term is an example of a "data term" as defined above. Similarly, the data fidelity term $DF$ can also penalise, for the targets of the first and second set of targets, large distances between the optimization variable $X_{SWL}$ and the dense POI data 610. To this end, the data fidelity term $DF$ can comprise a second (SWL) data fidelity term $DF_{SWL} = \|M_{SWL}X_{SWL} - W_{SWL}\|$, where $M_{SWL}$ denotes a binary selection mask which selects the elements of $X_{SWL}$ which correspond to targets for which SWL data is available, i.e. the elements for which $W_{SWL}$ contains measured values. The data fidelity term $DF$ can comprise a weighted combination of the first data fidelity term $DF_{MWL}$ and the second data fidelity term $DF_{SWL}$.

The spatial variation term $GP(X_{MWL})$ encodes prior process and application knowledge that guides the interpolation of $X_{MWL}$ (between the locations with accurate labels encoded in $M_{MWL}$). More specifically, the spatial variation term $GP(X_{MWL})$ encodes expert domain knowledge of the patterning process relating to the expected spatial variation of the POI across the substrate. For example, this domain knowledge may include the knowledge that the $X_{MWL}$ fingerprint is expected to be spatially smooth. This knowledge can be included via a term that penalizes spatial variations of $X_{MWL}$. For example, the spatial variation term $GP(X_{MWL})$ may include a total-variation penalty $GP(X_{MWL}) = \|X_{MWL}\|_{TV}$ (where the index "TV" indicates a total-variation norm). Thus, in this case, the spatial variation term $GP(X_{MWL})$ encourages a low-varying interpolating solution $X_{MWL}$. As noted above, the regularization parameter $\gamma_{GP}$ in Eq. (1) influences the degree to which this spatial variation term is enforced on the solution $X_{MWL}$.

The correlation term CR enables incorporating further data that is informative for relative quantities in $X_{MWL}$, i.e. the correlations between different target locations. For example, an assumption C on the covariance of the $X_{MWL}$

$$CR = \left\| C^{-\frac{1}{2}} X_{MWL} - I \right\|$$

fingerprint can be imposed via the following correlation prior     where $I$ denotes the identity matrix. The regularization parameter $\gamma_{CR}$ in Eq. (1) reflects the certainty of the prior covariance assumption.

Sometimes additional measured information is available that can be used to find suitable values for the $X_{MWL}$ fingerprint. The additional information may be obtained from a different substrate, e.g. a nominally identical or similar substrate. This information can also be incorporated into Eq. (1) via the correlation term $CR$ (in addition or as alternative to the aforementioned covariance term). As one example, sometimes multiple substrates are produced within one production lot, i.e. the substrate 601 may be the "i-th" substrate of a production lot of "N" nominally identical substrates, and the POI fingerprint $W_{j,MWL}$ ("third dataset") obtained for one of the other substrates in the same lot (identified by the index "j") can be helpful for finding suitable values for the $X_{MWL}$ fingerprint. This is because, in practice, intra-lot variations are normally low (e.g. lower than inter-lot variations). The information of the fingerprint $W_{0,MWL}$ can be incorporated into Eq. (1) in many ways, for example via a term that measures a discrepancy between the spatial gradient of $W_{j,MWL}$ and $X_{MWL}$, e.g.

$CR = $
$$\left\| \nabla W_{j,MWL} - \nabla X_{MWL} \right\|_2^2$$
. It is noted that the fingerprint $W_{j,MWL}$ can be more densely sampled than the fingerprint $W_{MWL}$ for substrate 601, i.e. the fingerprint $W_{j,MWL}$ can include POI values for a larger number of targets of the "j-th" substrate (e.g. all of the targets). This data is often readily available because, normally, one substrate per lot is densely inspected to derive calibration values for an asymmetry correction algorithm, as known to those skilled in the art.

In some implementations, the assumption of lower intra-lot variation than inter-lot variation may be explicitly encoded in the cost function by including a low-rank prior term, e.g. $\|[X_{1,MWL}, \cdots, X_{N,MWL}]\|_*$ where $\|\cdot\|_*$ denotes the nuclear norm. In broad terms, this term encodes the limited number of degrees of freedom that explains the intra-lot variation. It is to be understood that $N$ is selected to be larger than the expected minimal number of degrees of freedom explaining the intra-lot variation.

As another example, correlations between targets in the $W_{SWL}$ fingerprint can be informative of expected correlations between targets in the $X_{MWL}$ fingerprint. That is the correlation term may be selected so as to encourage a $X_{MWL}$ fingerprint that exhibits similar correlations to the correlations of the $W_{SWL}$ fingerprint. For example, the gradient of $W_{SWL}$ may be used to inform the gradient of $X_{MWL}$, e.g. $\|\nabla X_{MWL} - \nabla W_{SWL}\|_2^2$ where the lower index "2" indicates the L2 norm. That is while the $W_{SWL}$ fingerprints are normally biased to the SWL measurements, each target location in the fingerprint undergoes a qualitatively similar bias, and the gradients of the $W_{SWL}$ can therefore be informative for the gradients in $X_{MWL}$. In broad terms, the SWL data can be considered to include the aforementioned gradient bias overlapped with the POI fingerprint that exists in the MWL data. Thus, the aforementioned gradient correlation term aims to recover this partial information given the other terms, e.g. the data fidelity part with regards to the MWL fingerprint. In a way, this allows the partial use of all of the SWL measured data in a more flexible way, i.e. it is not required that the inferred POI is close to that measured via SWL, because this is replaced by the rate of change of the fingerprint which is less restrictive.

The denoising term $DN$ encodes prior knowledge of the respective "stochastic noise" contribution over the SWL and MWL fingerprints. For example, the denoising prior may take the form of $DN_{SWL} = \|W_{SWL} - M_{SWL} X_{SWL}\|_2^2$. This example of an L2-norm encodes the prior expectation that there is normally distributed noise that has polluted the $W_{SWL}$ fingerprints. Thus, the denoising term encourages a $X_{SWL}$ fingerprint with less "stochastic noise" than the "original" $W_{SWL}$ fingerprint. Alternatively or additionally, the denoising term may include a similar term for the MWL fingerprints,

$$DN_{MWL} = \|W_{MWL} - X_{MWL}\|_2^2$$ (this term can also be considered to be an implementation of the aforementioned data fidelity term).

In some embodiments, in addition to $W_{MWL}$, one or more further sparse but highly accurate fingerprints may be available and may be incorporated in Eq. (1). Such an additional fingerprint may have been derived from metrology data generated based on a third metrology process (e.g. MWL image data generated using a different set of wavelengths compared to the first metrology process implemented by metrology system 602, metrology data generated using a SEM-based metrology process, and the like). In these cases, Eq. (1) may additional terms which may correspond to one or

more of the above-described cost terms where $W_{MWL}$ is replaced with the additional fingerprint. The use of multiple sparse but highly accurate fingerprints is helpful to further reduce bias in the optimized fingerprint $X_{MWL}$.

As noted above, the specific form of the cost function Eq. (1) depends on implementation details. To illustrate this further, a specific example application of μDBO overlay inference is now considered. In this example scenario, the optimization routine is used to determine the $X_{i,MWL}$ fingerprint for substrate *i* of a production lot of "N" nominally identical substrates ("N" may be in the range of 5 to 20). The fingerprint is determined based on the sparse fingerprint $W_{i,MWL}$ and the dense fingerprint $W_{i,SWL}$ obtained by inspecting substrate *i*, and the medium dense fingerprint $W_{j,MWL}$ obtained by inspecting substrate *j* of the production lot. In this example, the $X_{i,SWL}$ fingerprint is not used as an optimization variable and the occurrences of $X_{SWL}$ in the aforementioned cost terms can be replaced with the measured $W_{i,SWL}$ fingerprint). Thus, in this case, the optimization problem of Eqs. (1) and (2) may take the form:

$$\operatorname*{argmin}_{X_{MWL}} \|M_{i,MWL}X_{i,MWL} - W_{i,MWL}\|_2^2 + \gamma_{GP}\|X_{i,MWL}\|_{TV} + \gamma_{CR,1}\|\nabla X_{i,MWL} - \nabla W_{i,SWL}\|_2^2 +$$

$$\gamma_{CR,2}\|\nabla W_{j,MWL} - \nabla X_{i,MWL}\|_2^2 \qquad\qquad \text{Eq. (3)}$$

which includes implementations of the some of the aforementioned cost terms. More specifically, the first term in Eq. (3) is an implementation of the data fidelity term in which the Euclidean norm is used to encode the assumption of normally distributed noise on top of the reference values $W_{MWL}$. The second term of Eq. (3) implements the aforementioned spatial variation term where the total-variation norm encodes the application knowledge that the $X_{i,MWL}$ fingerprint is predominantly low-frequent. The third term of Eq. (3) is a first correlation terms that implements the knowledge that the gradient of $W_{i,SWL}$ is informative of the gradient of $X_{i,MWL}$. The fourth term of Eq. (3) is a second correlation terms that implements the knowledge that the gradient of $W_{j,MWL}$ is informative of the gradient of $X_{i,MWL}$.

The optimization problem of Eqs. (1-3) may be solved using any suitable optimization algorithm/solver. More specifically, the optimization algorithm may be selected based on the terms of Eqs. (1-3) in a specific implementation. In some cases, the optimization algorithm may be selected to support both differentiable and non-differentiable terms. The optimization solvers may be a (non)convex proximal solver, that supports differentiable cost terms with gradient descent and non-differentiable cost terms with proximal operators (if these terms are convex).

While the processing unit 606 has been described as generating the predicted POI data 611 by solving the optimization problem of Eqs. (1-3), it is to be understood that, in other implementations, the processing unit 606 may be configured to generate the predicted POI data 611 based on the above-described cost function (Eq. 1) but without explicitly performing an iterative optimization by minimizing the cost function. Instead, the processing unit 606 may implement a trained machine learning model (e.g. trained neural network) which has been trained using the cost function as a training objective and a training dataset to learn to map the sparse POI data 609 and the dense POI data 610 to predicted POI data 611. The training dataset may include training items, each including corresponding training sparse POI data, training dense POI data, and training predicted POI data.

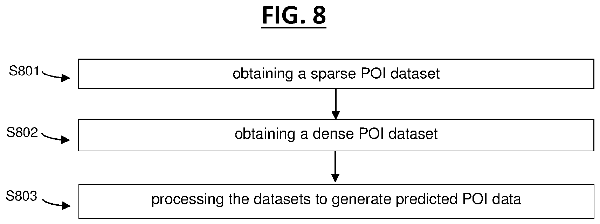

An example process of using the system 600 to generate the predicted POI data 611 is described with reference to Figure 8. At step S801, the sparse POI dataset 609 is obtained. This can involve inspecting the targets of the second set of targets of the substrate 601 using the first metrology system 602 to generate the sparsely sampled metrology data 607, and converting the sparsely sampled metrology data 607 into the sparse POI dataset 609 using the first POI module 604. At step S802, the dense POI dataset 610 is obtained. This may involve inspecting the targets of the first and second sets of targets of the substrate 601 using the second metrology system 603 to generate the densely sampled metrology data 608, and converting the densely sampled metrology data 608 into the dense POI dataset 610 using the second POI module 605.

At step S803, the predicted POI data 611 is generated by processing, using the processing unit 606, the sparse POI data 609 and the dense POI dataset 610. This can involve performing an iterative process varying candidate values of the predicted POI data 611 to reduce the value of the above-described cost function $\mathcal{L}$ (Eq. (1). The iteration may be performed until a termination criterion is met (e.g. a certain number of iterations have been performed, or the most recent iteration reduced the cost function by an amount below a threshold).

As noted above, the targets which are sampled by the first metrology system, i.e. the targets which are assigned to form the second set of targets, can be randomly selected from the plurality of targets. The inventors have realized that system throughout can be further improved by optimizing the selection of targets that form the second set of targets. In broad terms, the targets that form the second set of targets can be selected by performing a weakly supervised optimization algorithm that minimizes the number of required measurements (using the first metrology system 602) to generate the predicted POI data 611 in a reliable manner. As described below in more detail, this optimization algorithm involves defining a convex relaxation of the binary target selection problem to define a continuous trajectory between different target sampling schemes that concludes in an optimized target sampling scheme.

Generally, the proposed optimization algorithm processes POI fingerprint data obtained for a reference substrate that is nominally identical to substrate 601. This reference substrate may be a substrate patterned as part of the same production lot, as described above, but this is not strictly necessary. More specifically, the proposed optimization algorithm processes a densely sampled POI fingerprint $\tilde{W}_{MWL}$ ("fourth dataset") obtained from metrology data obtained by applying the first metrology process to each of the targets of the reference substrate, and a densely sampled POI fingerprint $\tilde{W}_{SWL}$ ("fifth dataset") obtained from metrology data obtained by applying the second metrology process to each of the targets of the reference substrate (where the tilde on top of the symbols is used to distinguish the symbols from the corresponding symbols of Eqs. (1)-(3)). The fingerprints $\tilde{W}_{MWL}$ and $W_{SWL}$ may be processed to determine the above-described binary mask data $M_{MWL}$ (i.e. the binary dataset that specifies the second set of targets) as an additional step of the process of Figure 8, i.e. as an initial step preceding step S801.

The selection of targets that form the second set of targets can be optimized by including the binary mask $M_{MWL}$ as optimization variable in the optimization problem of Eqs. (1) and (2), e.g.

$$\underset{\tilde{X}_{MWL}, M_{MWL}}{argmin} \left\| M_{MWL}\tilde{X}_{MWL} - \tilde{W}_{MWL} \right\|_2^2 + \gamma \, g\big(\tilde{X}_{MWL}, \tilde{W}_{SWL}\big) \qquad \text{Eq. (4)}$$

with $M_{MWL}[i, j] \in \{0,1\} \; \forall \; i, j$ (where $i$ and $j$ are indices of matrix elements of $M_{MWL}$), and where $g(\cdot)$ denotes the terms of the cost function $\mathcal{L}$ (evaluated for $\tilde{X}_{MWL}$, $\tilde{W}_{SWL}$) except for the data fidelity term which corresponds to the first term of Eq. 4. However, finding the optimal mask $M_{MWL}$ by solving Eq. (4) is computationally difficult because Eq. (4) describes both a combinatorial problem and a non-convex cost function.

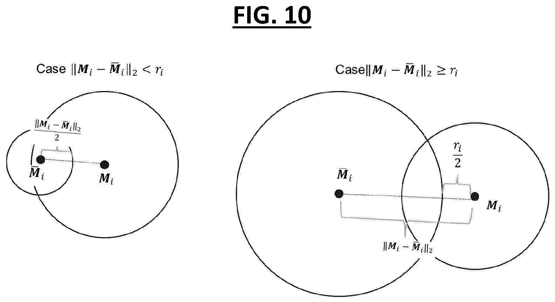

In broad terms, the inventors have realised that at least some of the aforementioned problems can be overcome by replacing the binary $M_{MWL}$ with a continuously scaling operator $M$ that weighs the importance of each target location, i.e. the importance of each target to be assigned to the second set of targets. This allows for non-combinatorial optimization of continuous variables. To generate the binary mask $M_{MWL}$ as output of the optimization, the continuous scaling operator $M$ can be restricted to convex regions $\mathcal{C}$ and $\bar{\mathcal{C}}$ which enables convergence to binary solutions, as described below with reference Figures 9 and 10. The continuous scaling operator $M$ can be regularized toward sparse solutions to encourage a low cardinality of the resulting second set of targets.

Further, $X_{MWL}$ and $M$ can be updated sequentially rather than simultaneously, i.e. in a "coordinate descent"-like manner. This relaxes the problem to a convex cost and enables separation of "predictor" terms that only operate on $\tilde{X}_{MWL}$ or $M$ which is advantageous because "information leakage" can be avoided. Moreover, a penalty term on the complement of the mask, (1 - $M$), can be added to measure the cost of "de-prioritizing" a specific target in the scaling term $M$. This helps avoiding trivial solutions.

An example implementation of the proposed optimization routine is now described. This implementation includes an "outer loop" that can comprise a plurality of iterations. In each iteration of the outer loop, a first "inner loop" is performed followed by a second "inner loop". The process is described with reference to Figure 9 which illustrates the proposed optimization routine for an illustrative example of a two-dimensional continuous scaling operator $M$.

The first loop can comprise a plurality of iterations. In each iteration of the first inner loop, the optimization variables $\tilde{X}_{MWL}$ and $M$ are alternatingly updated. More specifically, the fingerprint $\tilde{X}_{MWL}$ may updated based on

$$\underset{\tilde{X}_{MWL}}{argmin} \left\| M \odot (\tilde{X}_{MWL} - \tilde{W}_{MWL}) \right\|_2^2 + \gamma \, g(\tilde{X}_{MWL}, \tilde{W}_{SWL}) \qquad \text{Eq. (5)}$$

where $\odot$ denotes the Hadamard product, and $\gamma$ is a hyperparameter. The minimization of Eq. (5) may be performed iteratively over $n_2$ steps. Once $\tilde{X}_{MWL}$ is updated, the continuous scaling operator $M$ is updated based on

$$\underset{M}{argmin} \; \left\| (1 - M) \odot (X_{DWL} - W_{DWL}) \right\|_2^2 + \lambda \|M\|_1 \quad \text{Eq. (6)}$$

where the last term represents the above-described regularization of the continuous scaling operator $M$ to encourage a low cardinality of the resulting second set of targets, and $\lambda$ is a hyperparameter. The optimization of Eq. (6) may be performed iteratively over $n_3$ steps, i.e. $n_2$ and $n_3$ are hyperparameters that define the number of "coordinate descent" steps when updating $\tilde{X}_{MWL}$ and $M$. Further, the optimization variables $\tilde{X}_{MWL}$ and $M$ are updated according to Eqs. (5) and (6) such that $0 \leq M[i, j] \leq 1 \, \forall \, i,j$, $M \in \mathcal{C}$, and $M \in \bar{\mathcal{C}}$. In this way, the optimization variables $\tilde{X}_{MWL}$ and $M$ are alternatingly updated until convergence, or until some other termination criterion is met (e.g. a certain number of iterations have been performed).

An example iteration of the first inner loop is illustrated in panel 900 of Figure 9 which shows the cost landscape 901 (as a heatmap with darker regions indicating regions in which the cost function takes lower values), the continuous scaling operators $M_1$ and $M_2$ (where the indices indicate the respective iteration numbers of the outer loop), and the convex regions $\mathcal{C}_1$ and $\bar{\mathcal{C}}_1$. It can be seen that, in this example, the convex region $\mathcal{C}_1$ is a circle of radius $r_1$ centered at the continuous scaling operators $M_1$ (i.e. the continuous scaling operators at iteration 1) which overlaps with the convex region $\bar{\mathcal{C}}_1$ (a circle of radius $\bar{r}_1$ and centered at $\bar{M}_1$, as described below in more detail) as indicated by reference numeral 902. As illustrated in panel 900, the effect of the iteration of the first inner loop is that the continuous scaling operator is updated to $M_2$ such that i) $M_2$ lies in the overlap region 902 and ii) the value of the cost function is minimized. It is to be understood that, in a practical implementation, the continuous scaling operator $M$ is high-dimensional. Thus, in these cases, the convex sets $\mathcal{C}$ and $\bar{\mathcal{C}}$ may be hyperspheres.

In the second inner loop, $\mathcal{C}$ and $\bar{\mathcal{C}}$ are iteratively updated to encourage convergence to a binary solution of the continuous scaling operator $M$. Many ways of updating the convex sets exist. For example, the convex sets may be updated based on a heuristic shrinking scheme which reduces the size of the convex sets with each iteration of the outer loop. More specifically, the convex set $C$ for iteration $i$ may be defined as $\mathcal{C}_i = \mathcal{B}(M_i, r_i)$ i.e. a hypersphere with centroid $M_i$ and radius $r_i = \max\left\{0.01, \frac{\sqrt{\#(0.1 < M_i < 0.9)}}{10}\right\}$. Similarly, the convex set $\bar{\mathcal{C}}$ for iteration $i$ may be defined as $\bar{\mathcal{C}}_i = \mathcal{B}(\bar{M}_i, \bar{r}_i)$ i.e. a hypersphere with the "binary-solution" encouraging centroid $\bar{M}_i := h(M_i)$ and radius

$$\bar{r}_i = \|M_i - \bar{M}_i\|_2 / 2, \qquad \text{if } \|M_i - \bar{M}_i\|_2 < r_i$$
$$= \|M_i - \bar{M}_i\|_2 - r_i / 2, \qquad \text{otherwise}$$

where the condition $\|M_i - \bar{M}_i\| \leq r_i + \bar{r}_i$ guarantees that the two constraining hyperspheres have nonzero overlap, i.e. $\mathcal{C}_i \cap \bar{\mathcal{C}}_i \neq \emptyset$, as illustrated in Figure 10. In broad terms, the function $h(M_i)$ is used to gradually move the center towards only having binary values 0 or 1 while at the same time shrinking the radius. This may be implemented by effectively applying a soft thresholding operation to the previous solution to define the centroid of the new constrains. For example, the function $h(M_i)$ may be implemented by first performing $\sigma(M_i) = 1/(1 + e^{-5M_i + 2.5})$ followed by rescaling to cover the range [0,1].

In broad terms, the first and the second inner loops define the inner iterations of a convex relaxation technique that iteratively pushes the continuous scaling operator $M$ toward a binary representation. This is illustrated in panels 910, 920 and 930 of Figure 9. Panel 910 shows that the continuous scaling operator $M_3$ for iteration 3 that has been determined based on the cost landscape and the updated (compared to panel 900) convex sets $\mathcal{C}_2$ and $\bar{\mathcal{C}}_2$. Panel 920 illustrates a further iteration step. Panel 930 shows the trajectory of the continuous scaling operator $M$ and the trajectory of the centroid of the convex set $\bar{\mathcal{C}}$ over the iterations of the outer loop. It can be seen that the continuous scaling operator $M$ convergences towards the binary solution (1,1), and that the convex sets $\mathcal{C}$ and $\bar{\mathcal{C}}$ shrink over the iterations of the outer loop.

Iterations of the outer loop are performed until the continuous scaling operator $M$ is close enough to a binary solution, e.g. until a metric measuring a distance of the continuous scaling operator $M$ to a binary solution is below a threshold value. The continuous scaling operator $M$ of the last iteration of the outer loop is then converted into the binary mask $M_{MWL}$. For example, when the outer optimization has converged, so that the continuous scaling operator $M$ is close to being binary, $M$ may be truncated to the closest binary target selection mask $M_{MWL}$.

Thus, the proposed hierarchical optimization routine enables minimizing the number of accurate MWL acquisitions that are necessary (in addition to densely sampled SWL acquisitions) to predict an accurate MWL-like POI fingerprint for targets across the substrate. Each iteration of the hierarchical optimization routine encourages convergence of the continuous values of $M$ toward the binary extremes 0 or 1 (via the above-described shrinking scheme), while being informed by the underlying cost-function that predicts appropriate corrections on $X_{MWL}$ (via the predicting cost). Together with the sparsity-inducing regularization $\lambda \|M\|_1$ in Eq. (6), this encourages good quality corrections on $X_{MWL}$ while encouraging "unimportant" elements in $W_{MWL}$ (for example, redundant reference information) to be removed by allowing associated elements in **M** to converge to 0.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Further embodiments are disclosed in the subsequent numbered clauses:

1. A method of predicting a value of a parameter of interest for a target of a first set of targets formed by a patterning process on a substrate comprising a plurality of targets, the plurality of targets comprising the first set of targets and a second set of targets which are different from the first set of targets; the method comprising:

obtaining a first dataset comprising, for each target of the second set, a respective value of the parameter of interest generated from metrology data obtained by applying a first metrology process to the second set of targets;
obtaining a second dataset comprising, for each target of the first set and each target of the second set, a respective value of the parameter of interest generated from metrology data obtained by applying a second metrology process to the first and second set of targets; and
processing the first dataset and the second dataset to predict the value of the parameter of interest for a target of the first set, wherein the predicted value is a prediction of the parameter of interest generated from metrology data obtained by applying the first metrology process to the target of the first set.

2. The method of clause 1, wherein processing the first dataset and the second dataset to predict the value of the parameter of interest for the target of the first set comprises:

using the first dataset and the second dataset to define a cost function of a respective candidate value of the parameter of interest for each target of the first set and for each target of the second set; and
predicting the respective value of the parameter of interest for the target of the first set based on the cost function.

3. The method of clause 2, wherein predicting the respective value of the parameter of interest for the target of the first set based on the cost function comprises:

performing an iterative process of varying the candidate values of the parameter of interest to reduce the value of the cost function; and
predicting the respective value of the parameter of interest for the target of the first set based on the respective candidate values resulting from the iterative process.

4. The method of clause 2 or 3, wherein the cost function comprises a data fidelity term measuring a discrepancy between the candidate values for the parameter of interest for the target of the second set and the corresponding values of the first dataset.

5. The method of clause 4, wherein the cost function further comprises a spatial variation term encoding domain knowledge of the patterning process relating to a spatial variation of the value of the parameter of interest across the targets of the first and second set.

6. The method of clause 5, wherein the spatial variation term measures a total-variation of the candidate value of the parameter of interest across the targets of the first and second set.

7. The method of any of one of clauses 2 to 6, wherein the cost function comprises a first correlation term measuring a correlation between the candidate values of the parameter of interest across the targets of the first and second set.

8. The method of clause 7, wherein the first correlation term measures a covariance of the candidate values of the parameter of interest across the targets of the first and second set.

9. The method of any of one of clauses 2 to 8, wherein the cost function further comprises a second correlation term measuring a discrepancy between a spatial gradient of the candidate values of the parameter of interest and corresponding spatial gradient values based on the second dataset.

10. The method of any of one of clauses 2 to 9, wherein the substrate is a first substrate, and the method further comprises:

obtaining a third dataset comprising, for at least one target of the first set of targets, a respective value of the parameter of interest generated from metrology data obtained by applying the first metrology process to the respective target of a second substrate that is different from but nominally identical to the first substrate, and wherein the cost function further comprises a third correlation term measuring a correlation between the candidate values of the parameter of interest and corresponding values of the third dataset.

11. The method of clause 10, wherein the third correlation term measures a discrepancy between the candidate values of the parameter of interest and the corresponding values of the third dataset.

12. The method of clause 10, wherein the third correlation term measures a discrepancy between a spatial gradient of the candidate values of the parameter of interest and a spatial gradient of the corresponding values of the third dataset.

13. The method of any of one of clauses 2 to 12, wherein the cost function is additionally a function of a respective correction value for each of the values of the second dataset, and wherein the cost function comprises a data fidelity term based on the candidate values of the parameter of interest and the correction values, and at least one second correlation term measuring a discrepancy between candidate correction values of the first set of targets and corresponding values of the second dataset.

14. The method of clause 13, when dependent on clause 9, wherein the second correlation term measures a discrepancy between a spatial gradient of the candidate values of the parameter of interest and corresponding spatial gradient values for the second dataset.

15. The method according to any preceding clause, wherein the substrate is a first substrate, and the method further comprises:

obtaining a fourth dataset comprising, for each target of the plurality of targets of a reference substrate that is nominally identical to the first substrate, a respective value of the parameter of interest generated from metrology data obtained by applying the first metrology process to the targets, and obtaining a fifth dataset comprising, for each target of the plurality of targets of the reference substrate, a respective value of the parameter of interest generated from metrology data obtained by applying the second metrology process to the targets, processing the fourth dataset and the fifth dataset to obtain mask data specifying an assignment of each of the plurality of targets to either the first set of targets or the second set of targets.

16. The method of clause 15, wherein obtaining the first dataset comprises:

applying, based on the mask data, the first metrology process to each of the targets of the first set of targets of the substrate to generate corresponding metrology data; processing the generated metrology data to determine corresponding values of the parameter of interest.

17. The method of clause 15 or 16, wherein processing the fourth dataset and the fifth dataset to obtain mask data specifying an assignment of each target to either the first subset or the second subset comprises:

processing the fourth dataset and the fifth dataset to obtain the mask data based on a second cost function comprising i) a respective data fidelity term measuring, based on candidate mask data, a discrepancy between candidate values for the parameter of interest for each target of the second set according to the candidate mask data and the corresponding values of the fourth dataset, and ii) one or more of: a respective gradient term encoding domain knowledge of the patterning process relating to a spatial variation of the value of the parameter of interest across the targets of the first and second set; a respective first correlation term measuring a correlation between the candidate values of the parameter of interest across the targets of the first and second set; a respective second correlation term measuring a discrepancy between a spatial gradient of the candidate values of the parameter of interest and corresponding values of the fifth dataset.

18. The method of clause 17, wherein processing the fourth dataset and the fifth dataset to obtain the mask data based on a second cost function comprises:

over a plurality of iterations, alternatingly optimizing i) data relating to the candidate mask data and ii) the candidate values for the parameter of interest for each target of the second set based on the second cost function, and
providing the candidate mask data of the last iteration as the mask data.

19. The method of clause 18, wherein over a plurality of iterations, alternatingly optimizing i) data relating to the candidate mask data and ii) the candidate values for the parameter of interest for each target of the second set based on the second cost function comprises:

performing a first iteration routine comprising a plurality of first iteration steps, each first iteration step comprising:

updating a continuously scaling operator specifying a respective weight for each target based on the second cost function, wherein the weight is indicative of an importance of the target for the optimization of the candidate values for the parameter of interest for each target of the second set; and
updating, separately from the updating of the continuously scaling operator, the candidate values for the parameter of interest for each target of the second set based on the second cost function;

performing a second iteration routine comprising a plurality of second iteration steps, each second iteration step comprising processing the continuously scaling operator to encourage convergence to binary values;
and generating the mask data from the processed continuously scaling operator.

20. The method of clause 19, wherein the first and the second iteration routines are alternatingly performed a plurality of times, and the mask data is generated from the processed continuously scaling operator obtained in the last iteration of the second iteration routine.

21. The method according to any preceding clause, wherein the plurality of targets comprise a third set of targets for which the first and second datasets do not comprise corresponding data elements, and the first dataset and the second dataset are processed to predict the respective value of the parameter of interest for each target of the first set and for each target of the third set.

22. The method according to any preceding clause, wherein the first metrology process comprises a multi-wavelength acquisition, and the second metrology process comprises a single-wavelength measurement.

23. The method according to any preceding clause, wherein the first metrology process comprises an optical metrology process using light having a first polarization state, and the second metrology comprises an optical metrology process using light having a second polarization state that is different from the first polarization state.

24. The method according to any preceding clause, wherein the first metrology process comprises measuring the substrate both at 0-degree rotation and at 180-degree rotation, and the second metrology process comprises measuring the substrate only at 0-degree rotation.

25. The method according to any preceding clause, wherein the first metrology process comprises measuring two grating light valve spectra, and the second metrology process comprises measuring one grating light valve spectrum.

26. The method according to any preceding clause, wherein the substrate is a semiconductor wafer patterned using a lithography apparatus.

27. The method according to any preceding clause, wherein the metrology data that has been used to generate the datasets is after development inspection, ADI, metrology data or after etch inspection, AEI, metrology data.

28. The method according to any preceding clause, wherein each target comprises a structure, and the parameter of interest characterizes the geometry and/or material properties of the structure.

29. The method according to clause 28, wherein the parameter of interest is one of:

an overlay value characterizing relative positions of structures of the target in directions in the plane of the major surface of the substrate;
a critical dimension value characterizing one or more dimensions of the structure of the target;
a side wall angle of a wall of the structure of the substrate; and
a measure of a tilt of the structure of the target.

30. A computer program product comprising machine-readable instructions which, when the program is executed by a computer, cause the computer to carry out the method of any preceding clause.

31. A metrology apparatus for predicting a value of a parameter of interest for a target of a first set of targets formed by a patterning process on a substrate comprising a plurality of targets, the plurality of targets comprising the first set of targets and a second set of targets which are different from the first set of targets;
the metrology apparatus comprising:

a first metrology system configured apply a first metrology process to the second set of targets to obtain first metrology data;
a second metrology system configured apply a second metrology process to the first and second set of targets to obtain second metrology data;
a processing unit configured to:

process the first metrology data to obtain a first dataset comprising, for each target of the second set, a respective value of the parameter of interest;
process the second metrology data to obtain a second dataset comprising, for each target of the first set and each target of the second set, a respective value of the parameter of interest generated from metrology data obtained by applying a second metrology process to the first and second set of targets; and
processing the first dataset and the second dataset to predict the value of the parameter of interest for a target of the first set, wherein the predicted value is a prediction of the parameter of interest generated from metrology data obtained by applying the first metrology process to the target of the first set.

**Claims**

1. A method of predicting a value of a parameter of interest for a target of a first set of targets formed by a patterning process on a substrate comprising a plurality of targets, the plurality of targets comprising the first set of targets and a second set of targets which are different from the first set of targets;
the method comprising:

obtaining a first dataset comprising, for each target of the second set, a respective value of the parameter of interest generated from metrology data obtained by applying a first metrology process to the second set of targets;
obtaining a second dataset comprising, for each target of the first set and each target of the second set, a respective value of the parameter of interest generated from metrology data obtained by applying a second metrology process to the first and second set of targets; and
processing the first dataset and the second dataset to predict the value of the parameter of interest for a target of the first set, wherein the predicted value is a prediction of the parameter of interest generated from metrology data obtained by applying the first metrology process to the target of the first set.

2. The method of claim 1, wherein processing the first dataset and the second dataset to predict the value of the parameter of interest for the target of the first set comprises:

using the first dataset and the second dataset to define a cost function of a respective candidate value of the parameter of interest for each target of the first set and for each target of the second set; and
predicting the value of the parameter of interest for the target of the first set based on the cost function,
and optionally, wherein predicting the respective value of the parameter of interest for the target of the first set based on the cost function comprises:

performing an iterative process of varying the candidate values of the parameter of interest to reduce the value of the cost function; and
predicting the respective value of the parameter of interest for the target of the first set based on the respective candidate values resulting from the iterative process.

3. The method of claim 2, wherein the cost function comprises a data fidelity term measuring a discrepancy between the candidate values for the parameter of interest for the target of the second set and the corresponding values of the first dataset.

4. The method of claim 3, wherein the cost function further comprises a spatial variation term encoding domain knowledge of the patterning process relating to a spatial variation of the value of the parameter of interest across the targets of the first and second set.

5. The method of any of one of claims 2 to 4, wherein the cost function comprises a first correlation term measuring a correlation between the candidate values of the parameter of interest across the targets of the first and second set.

6. The method of any of one of claims 2 to 5, wherein the cost function further comprises a second correlation term measuring a discrepancy between a spatial gradient of the candidate values of the parameter of interest and corresponding spatial gradient values based on the second dataset.

7. The method of any of one of claims 2 to 6, wherein the substrate is a first substrate, and the method further comprises: obtaining a third dataset comprising, for at least one target of the first set of targets, a respective value of the parameter of interest generated from metrology data obtained by applying the first metrology process to the respective target of a second substrate that is different from but nominally identical to the first substrate, and wherein the cost function further comprises a third correlation term measuring a correlation between the candidate values of the parameter of interest and corresponding values of the third dataset.

8. The method according to any preceding claim, wherein the substrate is a first substrate, and the method further comprises:

   obtaining a fourth dataset comprising, for each target of the plurality of targets of a reference substrate that is nominally identical to the first substrate, a respective value of the parameter of interest generated from metrology data obtained by applying the first metrology process to the targets, and
   obtaining a fifth dataset comprising, for each target of the plurality of targets of the reference substrate, a respective value of the parameter of interest generated from metrology data obtained by applying the second metrology process to the targets,

      processing the fourth dataset and the fifth dataset to obtain mask data specifying an assignment of each of the plurality of targets to either the first set of targets or the second set of targets,
      and optionally, wherein obtaining the first dataset comprises:

   applying, based on the mask data, the first metrology process to each of the targets of the first set of targets of the substrate to generate corresponding metrology data;
   processing the generated metrology data to determine corresponding values of the parameter of interest.

9. The method of claim 8, wherein processing the fourth dataset and the fifth dataset to obtain mask data specifying an assignment of each target to either the first subset or the second subset comprises:
   processing the fourth dataset and the fifth dataset to obtain the mask data based on a second cost function comprising i) a respective data fidelity term measuring, based on candidate mask data, a discrepancy between candidate values for the parameter of interest for each target of the second set according to the candidate mask data and the corresponding values of the fourth dataset, and ii) one or more of:

   a respective gradient term encoding domain knowledge of the patterning process relating to a spatial variation of the value of the parameter of interest across the targets of the first and second set;
   a respective first correlation term measuring a correlation between the candidate values of the parameter of interest across the targets of the first and second set;
   a respective second correlation term measuring a discrepancy between a spatial gradient of the candidate values of the parameter of interest and corresponding values of the fifth dataset.

10. The method according to any preceding claim, wherein the first metrology process comprises a multi-wavelength acquisition, and the second metrology process comprises a single-wavelength measurement; and/or wherein the first metrology process comprises an optical metrology process using light having a first polarization state, and the second metrology comprises an optical metrology process using light having a second polarization state that is different from the first polarization state.

11. The method according to any preceding claim, wherein the substrate is a semiconductor wafer patterned using a lithography apparatus.

12. The method according to any preceding claim, wherein the metrology data that has been used to generate the datasets is after development inspection, ADI, metrology data or after etch inspection, AEI, metrology data.

13. The method according to any preceding claim, wherein each target comprises a structure, and the parameter of interest characterizes the geometry and/or material properties of the structure.

14. A computer program product comprising machine-readable instructions which, when the program is executed by a computer, cause the computer to carry out the method of any preceding claim.

15. A metrology apparatus for predicting a value of a parameter of interest for a target of a first set of targets formed by a patterning process on a substrate comprising a plurality of targets, the plurality of targets comprising the first set of targets and a second set of targets which are different from the first set of targets;
the metrology apparatus comprising:

a first metrology system configured to apply a first metrology process to the second set of targets to obtain first metrology data;
a second metrology system configured to apply a second metrology process to the first and second set of targets to obtain second metrology data;
a processing unit configured to:

process the first metrology data to obtain a first dataset comprising, for each target of the second set, a respective value of the parameter of interest;
process the second metrology data to obtain a second dataset comprising, for each target of the first set and each target of the second set, a respective value of the parameter of interest generated from metrology data obtained by applying a second metrology process to the first and second set of targets; and
processing the first dataset and the second dataset to predict the value of the parameter of interest for a target of the first set, wherein the predicted value is a prediction of the parameter of interest generated from metrology data obtained by applying the first metrology process to the target of the first set.

# Fig. 1

# Fig. 2

# Fig. 3

LA

SC1

SC3

CL

-1    0    +1

MT

SC2

SM1

2

4

5    10

Z

X

PU

W

I

6

Z

8

λ

X

# Fig. 4

# Fig. 5

# Fig. 6

600

Substrate 601

Metrology system 602

Metrology system 603

Sparsely sampled metrology data 607

Densely sampled metrology data 608

POI module 604

POI module 605

Sparse POI data 609

Dense POI data 610

Processing unit 606

Predicted POI data 611

Fig. 7

# FIG. 8

S801 → | obtaining a sparse POI dataset |

S802 → | obtaining a dense POI dataset |

S803 → | processing the datasets to generate predicted POI data |

# FIG. 9

# FIG. 10

Case $\|M_i - \bar{M}_i\|_2 < r_i$

Case $\|M_i - \bar{M}_i\|_2 \geq r_i$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 2007224518 A
- US 2019003988 A1
- US 2019215940 A1
- US 20130304424 A1
- US 2014019097 A1, Bakeman

**Non-patent literature cited in the description**

- **LEMAILLET et al.** Intercomparison between optical and X-ray scatterometry measurements of FinFET structures. *Proc. of SPIE*, 2013, 8681